# EUROPEAN PATENT APPLICATION

(11) **EP 1 463 128 A2**
(43) Date of publication of application: **29.09.2004**
(21) Application number: 04007128.4
(22) Date of filing: 24.03.2004
(51) Int. Cl.: H01L 31/18, C25D 9/04

(54) **Method of producing photovoltaic device**

(30) Priority: 26.03.2003 JP 2003085880; 10.03.2004 JP 2004066561
(71) Applicant: CANON KABUSHIKI KAISHA, Ohta-ku, Tokyo (JP)
(72) Inventor: Nakamura, Tetsuro, Tokyo (JP); Sano, Masafumi, Tokyo (JP)
(74) Representative: Leson, Thomas Johannes Alois, Dipl.-Ing.

(57) **Abstract**

There is disclosed a method of producing a photovoltaic device, characterized in that it includes steps of: a step of forming a zinc oxide layer on a substrate at least by electrolytic deposition; subjecting the zinc oxide layer to any one treatment selected from the group consisting of plasma treatment with a rare gas or nitrogen gas, ion irradiation, light irradiation and electromagnetic irradiation; and forming on the zinc oxide layer a semiconductor layer that are made up of a non-single crystal silicon material containing hydrogen and have at least one p-i-n junction.

## Description

### BACKGROUND OF THE INVENTION

### Field of the Invention

The present invention relates to a method of producing a photovoltaic device. The invention is applicable to methods of producing, for example, a photovoltaic device made up of a silicon non-single crystal semiconductor material or a photovoltaic device such as optical sensor.

### Related Background Art

In recent years, as worldwide power demand has rapidly increased and power production has been actively pursued to meet such demand, serious problems have arisen with environmental pollution. Under these conditions, electric power generation methods using a photovoltaic device, which utilizes the sun's rays, have lately attracted considerable attention as clean electric power generation methods which are probably capable of coping with future increase in power demands while avoiding environmental disruption, because they do not cause problems with, for example, contamination by radiation and global warming by the release of greenhouse effect gases, their energy sources are less maldistributed because the sun's rays pour all parts of the earth, and because they provides relatively high electricity generation efficiency while requiring no complicated and large-scale facility. And various investigations and developments of such methods have been made aiming at the practical use thereof.

To establish an electric power generation method which uses a photovoltaic device as a method capable of meeting the power demand described above, the photovoltaic device is required basically to have sufficiently high photoelectric conversion efficiency, excel in characteristic stability and be able to be mass-produced at low cost.

To enhance the light collecting efficiency at long wavelengths, a back-side reflecting layer is used in a photovoltaic device. As such a reflecting layer, is preferable a layer which exhibits effective reflecting characteristics at wavelengths near the band edge of semiconductor materials and where its absorption decreases, specifically at wavelengths of 800 nm to 1,200 nm. Layers that meet the above requirements include, for example, layers of metals, such as gold, silver, copper and aluminum, and the alloys thereof. Further, attempts have been made to improve short-circuit current density Jsc by making effective use of reflecting light while providing an uneven transparent conductive layer, which is optically transparent in the specified wavelength range, known as optical confinement. The transparent conductive layer also serves to prevent the deterioration in characteristics caused by a shunt path. Very generally, these layers are formed by vacuum evaporation or sputtering and contribute to the improvement in short-circuit current density.

For example, the reflectance and texture structure of reflecting layers made up of silver atom are examined in "Optical Confinement Effect in a-SiGe Solar Battery on 29p-MF-22 Stainless Substrate," (collected papers for 51st Academic Lecture by the Applied Physics Society of Japan, Fall, 1990): p747 and in Sannomiya et al., "P-IA-15a-SiC/a-Si/a-Sie Multi-Bandgap Stacked Solor Cells With Bandgap Profiling," Technical Digest of the International PVSEC-5 Kyoto, Japan, 1990: p381. These examples state that increase in short-circuit current has been accomplished in such a manner as to provide an effective unevenness by forming a reflecting layer as a two-layer deposit of silver while changing the substrate temperature and produce optical confinement effect by combining the uneven layer with a zinc oxide layer.

Japanese Patent No. 3273294 discloses that a zinc oxide layer formed using a zinc-oxide-layer forming electrolyte solution which is made up of an aqueous solution containing 0.001 mol/l to 0.5 mol/l of zinc ion and 0.001 mol/l to 0.5 mol/l of nitric acid ion is uniform in thickness and composition and excel in optical transparency.

Japanese Patent Application Laid-Open No. H10-140373 discloses that with a method of forming a zinc oxide thin film, characterized in that it includes: a step of forming a first zinc oxide thin film on a substrate by sputtering; and a step of forming a second zinc oxide thin film on the above first zinc oxide thin film in such a manner as to immerse the above substrate in an aqueous solution that contains at least nitric acid ion, zinc ion and carbohydrate and apply current across the substrate and an electrode having been immersed in the same solution, a zinc oxide thin film can be formed less costly, a zinc oxide thin film can be prevented from anomalously growing, and a zinc oxide thin film having excellent adhesion to a substrate can be formed.

Japanese Patent Application Laid-Open No. 2001-152390 discloses that a zinc oxide layer formed using a zinc-oxide-layer forming electrolyte solution which is made up of an aqueous solution shows a high electric resistance due to the water adsorbed thereon; however, the electric resistance can be decreased by heat drying the zinc oxide layer. Further, Japanese Patent Application Laid-Open No. 2002-237606 discloses that a solar cell produced in such a manner as to decrease the water content in a zinc oxide layer to 7.5 × 10⁻³ mol/cm³ and form a semiconductor layer on the zinc oxide layer has improved photoelectric conversion efficiency.

Japanese Patent Application Laid-Open No. 2001-339079 discloses a method of producing a photovoltaic device, characterized in that it includes: a step of treating the surface of a transparent conductive film of zinc oxide etc., with rare gas plasma; and a step of forming an amorphous semiconductor layer of one conductive type by deposition thereof on the surface area of the transparent conductive film having been treated with rare gas plasma. The specification states that the treating with rare gas plasma allows the formation of a low crystalline area on the surface of the transparent conductive film, which results in improvement in ohmic characteristics in the interface of the transparent conductive film and the semiconductor layer.

As described above, the use of a zinc oxide film electrochemically deposited from an aqueous solution as a reflecting layer of a solar cell permits the solar cell to be high in photoelectric conversion efficiency to some extent and less costly.

In the present state, however, several problems remain to be solved to realize a solar cell of high photoelectric conversion efficiency and less cost. To obtain a solar cell of higher conversion efficiency, for example, the electric resistance value of its zinc oxide layer has to be controlled in the optimum range, and at the same time, the transmittance of light also has to be controlled in the optimum range.

Thus, dehydrating treatment is indispensable to the zinc oxide layer prepared from an aqueous solution. However, in heat drying as means of dehydrating treatment, its temperature control is very difficult. With temperatures so high as to dispel all the water in the zinc oxide layer, the reflectance of the layer is lowered, whereas with insufficient heat drying, the water dispelled due to the temperature increase at the time of subsequent semiconductor layer and transparent electrode forming operations might become a source of contamination of the semiconductor layer and the transparent electrode.

Besides, the inventors of this invention found, during the course of this invention, that when forming a semiconductor layer on an insufficiently heat dried substrate, peeling could sometimes occur in the interface of the zinc oxide layer and the semiconductor film. This peeling might cause a shunt, and a problem arises with the reliability of the device in practical use.

Further, when a zinc oxide film is formed over a large area, due to the nonuniformity of its thickness or the variation in the crystal form, the film is not always dried uniformly even under the same drying conditions. Thus, when dry treating a great deal of zinc oxide films, the above described problems, due to the insufficient drying or overdrying of the film, remain to be solved.

### SUMMARY OF THE INVENTION

In the light of the above-described problems, the object of this invention is to dispel water in a zinc oxide layer formed from an aqueous solution while avoiding the deterioration in reflectance of the layer and provide a photovoltaic device on the zinc oxide layer which excels in adhesion to the layer, and hence frees from peeling.

Thus, this invention is a method of producing a photovoltaic device, characterized in that it includes: a step of forming a zinc oxide layer on a substrate at least by electrolytic deposition; a step of giving the zinc oxide layer any one treatment selected from the group consisting of plasma treatment with a rare gas or nitrogen gas, ion irradiation treatment, light irradiation treatment and electromagnetic irradiation treatment; and a step of forming on the zinc oxide layer a semiconductor layer that are made up of a non-single crystal silicon material containing hydrogen and have at least one p-i-n junction.

In this invention, it is preferable to give the zinc oxide layer rare gas plasma treatment, as the above treatment, using at least one rare gas selected from the group consisting of He, Ne, Ar, Kr and Xe.

It is also preferable to form another zinc oxide layer by sputtering before forming the above zinc oxide layer and use the same as an underlying layer.

Preferably the average thickness of the zinc oxide layer is 10 nm or more and 5 µm or less.

Preferably the zinc oxide layer transmits 50% or more of light with wavelength of 800 nm.

Preferably the zinc oxide layer has a resistivity lower than that of the p- or n-type semiconductor layer provided adjacent to the zinc oxide layer.

Preferably an adsorption preventive layer is provided between the zinc oxide layer and the p- or n-type semiconductor layer provided adjacent to the above zinc oxide layer.

According to this invention, water content in a zinc oxide layer which is formed from an aqueous solution can be reduced, while avoiding the deterioration in transmittance of the layer, by giving the layer plasma treatment with a rare gas or nitrogen gas, and besides, a semiconductor layer deposited on the zinc oxide layer is allowed to have high photoelectric conversion efficiency and be free from peeling, thereby a photovoltaic device that offers high efficiency and durability under various environmental conditions is realized.

### BRIEF DESCRIPTION OF THE DRAWINGS

FIG. 1 is a schematic view showing an embodiment of layer structure of a single-type photovoltaic device;
FIG. 2 is a schematic view of a batch processing apparatus for depositing zinc oxide layers by electrolytic deposition;
FIG. 3 is a schematic view of an apparatus for depositing a zinc oxide layer by electrolytic deposition;
FIG. 4 is a schematic view of a batch processing apparatus for producing photovoltaic devices of this invention;
FIG. 5 is a schematic view of an apparatus for producing a photovoltaic device of this invention; and
FIG. 6 is a schematic view of a drying chamber for drying a substrate.

### DESCRIPTION OF THE PREFERRED EMBODIMENTS

The inventors of this invention tried to reduce water content in a zinc oxide layer, which was formed on a substrate using a zinc oxide layer forming electrolyte solution made up of an aqueous solution, while avoiding the deterioration in transmittance of the same layer, and besides, increase the photoelectric conversion efficiency of a semiconductor layer deposited on the zinc oxide layer and prevent the peeling of the same by giving the zinc oxide layer plasma treatment with a rare gas or nitrogen gas.

In the following the advantages will be described which the preferred embodiments of this invention offer.

After directing tremendous research effort toward the solution of the above described problems, the inventors have found that a photovoltaic device offering high photoelectric conversion efficiency and durability under various environmental conditions can be produced in such a manner as to form a zinc oxide layer on a substrate by electrolytic deposition, give the zinc oxide layer surface plasma treatment using a rare gas or nitrogen gas, and form on the plasma treated zinc oxide layer semiconductor layers that are made up of non-single crystal silicon material containing hydrogen and have p-i-n junction. The treatment given the zinc oxide layer surface may be other than plasma treatment, for example, it may be ion irradiation treatment, light irradiation treatment or electromagnetic irradiation treatment. Preferably the treatment of this invention is carried out while avoiding the deterioration in crystallinity of the zinc oxide layer surface.

The circumstances and details of this invention will be described below in terms of treatment of the zinc oxide layer of this invention.

As described above, when a zinc oxide layer is formed using a zinc oxide layer forming electrolytic solution made up of an aqueous solution, water contamination of the layer is unavoidable; therefore, a step is required of removing water in the layer by heat drying after the layer formation. However, excessive heat drying causes deterioration in reflectance of the layer. This is probably because excessive heat drying dispels oxygen in the zinc oxide layer at the same time that it dispels water in the same and the layer becomes rich Zn. There is proposed a method in which heat drying is performed while controlling the temperature of the layer so as to prevent the deterioration in reflectance of the layer; however, it is very difficult to control the temperature of the layer. On the other hand, when water in the layer has not been removed sufficiently, the electric resistance of the layer becomes high due to the remaining water, and moreover, when a semiconductor is deposited on the layer, the curve factor significantly deteriorates, and besides, the peeling of the semiconductor can sometimes be detected.

Although the cause of the peeling is not clarified yet, it is possibly because water remaining in the zinc oxide layer comes out from the layer due to the temperature increase during the deposition of the semiconductor or in the post-step after the deposition, the vibration, etc., and cuts off the junction between the zinc oxide layer and the semiconductor layer.

It is very difficult, by heat drying so controlled that it does not allow the reflectance of a zinc oxide layer to deteriorate, to remove the water in the zinc oxide layer that is formed by electrolytic deposition to the level of the water in the zinc oxide layer that is formed by sputtering. Under such circumstances, the inventors thought that if the water content in the surface portion of the zinc oxide layer, which affected the junction portion between the zinc oxide layer and the semiconductor layer, was reduced to the level of the water content in the zinc oxide layer formed by sputtering, water, as a cause of peeling, would not come out from the layer. And they tried to give the surface of the zinc oxide layer plasma treatment.

As a gas used in plasma treatment of such a zinc oxide layer, preferably at least one selected from the group consisting of He, Ne, Ar, Kr, Xe and N₂ is used. When zinc oxide is heated in an atmosphere of, for example, hydrogen, it is reduced. And though the zinc oxide layer can be plasma treated depending on the kind of gas used, it is feared that the gas used is adsorbed on a surface of the zinc oxide layer or forms a compound on the same, which gives adverse effects on the semiconductor layer formed on the zinc oxide layer. Therefore, it is suitable to use a rare gas or nitrogen gas, which hardly affects the composition of zinc oxide. Of the above gases, rare gases are preferably used because of their extremely low reactivity. And He gas is more preferably used so as not to damage the zinc oxide layer excessively.

The inventors of this invention suppose that the mechanism to produce the effects of this invention is that the water content in the surface portion of the zinc oxide layer is reduced to the level of the water content in the zinc oxide layer formed by sputtering. The inventors also suppose, on the basis of the above supposed mechanism, that procedures other than plasma treatment can be used to reduce the water content selectively in the "surface" portion of the zinc oxide layer. For example, any one of the procedures such as ion irradiation treatment, light irradiation treatment and electromagnetic irradiation treatment can increase the temperature of the zinc oxide layer surface selectively; therefore, they are applicable to this invention as a "treatment" procedure. When giving ion irradiation treatment, low reactive ions (e.g., rare gases) are suitably used.

From the viewpoint of usability of the existing plasma treating apparatuses as they are (advantageousness in terms of apparatus costs), plasma treatment with a rare gas or nitrogen gas is preferable. Plasma treatment carried out using the same gas (a rare gas or nitrogen gas) as that used for forming a silicon material or for forming an underlying layer by sputtering, which is described later, is much more advantageous in terms of costs because a new gas line need not be installed.

When forming a zinc oxide layer by electrolytic deposition, it is preferable to use a zinc oxide layer formed by sputtering as an underlying layer. The use of a zinc oxide layer formed by sputtering as an underlying layer makes it easy to obtain a zinc oxide layer of large grain diameter and high diffused reflectance, because the zinc oxide formed by electrolytic deposition grows on the underlying zinc oxide layer using the underlying zinc oxide as a crystal nucleus.

Preferably the average film thickness of the zinc oxide layer is 10 nm or more and 5 µm or less. Since the effect as a reflecting layer is produced by the difference in refractive index in the interface between the reflecting layer and the zinc oxide layer, with too thin a zinc oxide layer, the effect cannot be obtained. Thus, the thickness is preferably 10 nm or more. On the other hand, the use of a zinc oxide layer 5 µm or more thick is not preferable, since the light reflected onto a bottom cell is reduced. More preferably the average film thickness of the zinc oxide layer is 100 nm or more and 5 µm or less, and optimally 1 µm or more and 5 µm or less.

It is preferable from the optical viewpoint that the zinc oxide film transmits 50% or more of light with wavelength of 800 nm. Considering the spectrum of the sun's rays, the wavelength range effectively used is roughly near 300 nm to 1,200 nm; accordingly, it is preferable for the zinc oxide layer to effectively transmit light with wavelengths in the above range while scattering the same. Preferably the transmittance of the zinc oxide layer is 50% or more at 800 nm, which is a measure of long wavelength, more preferably 60% or more and optimally 70% or more.

It is preferable from the viewpoint of series resistance that the resistivity of the zinc oxide layer is lower than that of the p- or n-type semiconductor layer provided adjacent to the zinc oxide layer, because the characteristics of the device can sometimes deteriorate when the zinc oxide layer has a higher resistivity than the p- or n-type semiconductor layer joined thereto.

As the unevenness of the zinc oxide layer surface increases, the area of the same increases and the characteristics of the photovoltaic device formed on such surface can sometimes deteriorate significantly. The reason of this has not been clarified yet, but it may be because impurity atoms in the p- or n-type semiconductor layer diffuse down into the intrinsic semiconductor. As a measure to prevent such deterioration of the device, preferably an adsorption preventive film is formed in which the amount of dopant is decreased compared with the p- or n-type semiconductor layer and a photovoltaic device is formed on the adsorption preventive film.

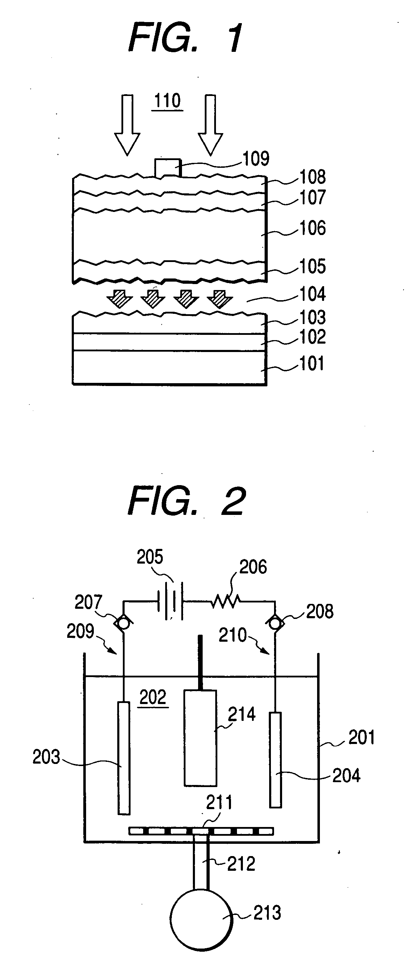

FIG. 1 shows a schematic cross-sectional view of a photovoltaic device produced in accordance with this invention. In the same figure, reference numeral 101 denotes a substrate (supporting member), numeral 102 a metal layer, numeral 103 a zinc oxide layer formed by electrolytic deposition, numerals 105, 106 and 107 semiconductor layers, numeral 108 a transparent electrode, and numeral 109 a collector electrode. Further, reference numeral 104 denotes treatment such as rare gas plasma treatment and numeral 110 the sun's rays. When a photovoltaic device is so constructed that light enters from the transparent substrate side, the layers except the substrate are formed in reverse order.

Then the constituents of the photovoltaic device produced in accordance with this invention will be described.

### (Substrate)

As the substrate 101 is used resin coated with a metal layer or an electrically conductive material, glass, ceramics, etc. The substrate 101 may have fine unevenness on its surface. A transparent substrate may be used so that light can enter from the substrate side. If the substrate is made in a continuous length, it can accommodate continuous film formation. Stainless steel and polyimide are particularly suitable to use for the substrate because of their flexibility.

### (Metal Layer)

The metal layer 102 functions as an electrode and as a reflecting layer which reflects light having reached the substrate 101 so that it is reused in the semiconductor layers. The metal layer is formed of Al, Cu, Ag or Au by the process such as evaporation, sputtering, electrolytic deposition or printing.

The metal layer 102 having unevenness on its surface has the function of extending the optical path length of reflected light in the semiconductor layers and increasing short-circuit current. When the substrate 101 is electrically conductive, the metal layer need not be formed.

### (Zinc Oxide Layer)

The zinc oxide layer 103 increases the diffused reflection of incident light and reflected light and extends the optical path length of the same in the semiconductor layers. Further, the zinc oxide layer prevents the elements in the metal layer from diffusing down or migrating into the semiconductor layers and the shunt from occurring in the photovoltaic device. Further, the moderate resistance of the zinc oxide layer prevents the occurrence of short-circuit due to the defects in the semiconductor layers such as pinholes. Preferably the zinc oxide layer 103 has unevenness on its surface, just as does the metal layer 102.

The zinc oxide layer 103 is formed by electrolytic deposition described below. Preferably the zinc oxide layer is deposited by electrolytic deposition on a zinc oxide film that has been provided in advance by sputtering etc., on the metal layer 102. This produces the effect of improving the adhesion between the metal layer 102 and the zinc oxide layer 103.

### (Process of Forming Zinc Oxide Layer by Electrolytic Deposition)

The zinc oxide layer 103 can be formed using, for example, an apparatus shown in FIG. 2. In the same figure, reference numeral 201 denotes a corrosion-resistant container, numeral 202 an aqueous solution for electrolytic deposition, numeral 203 a substrate, numeral 204 a counter electrode, numeral 205 a power source, numeral 206 a loading resistor, numeral 207 a substrate supporting shaft, numeral 208 an electrode supporting shaft, numeral 209 a substrate branch bone, numeral 210 an electrode branch bone, numeral 211 an air ejecting opening, numeral 212 an air ejecting pipe, numeral 213 an air ejecting pump, and numeral 214 a stirrer.

As the aqueous solution for electrolytic deposition 202 is used an aqueous solution containing at least zinc ion and nitric acid ion, and besides, saccharose or dextrin. The concentration of zinc ion is preferably 0.002 mol/l to 3.0 mol/l, more preferably 0.01 mol/l to 1.5 mol/l and optimally 0.05 mol/l to 0.7 mol/l. The concentration of nitric acid ion is preferably 0.004 mol/l to 6.0 mol/l, more preferably 0.01 mol/l to 1.5 mol/l and optimally 0.1 mol/l to 1.4 mol/l. The concentration of saccharose is 1 g/l to 500 g/l and more preferably 3 g/l to 100 g/l and the concentration of dextrin is 0.01 g/l to 10 g/l and more preferably 0.025 g/l to 1 g/l. Controlling the concentration of each constituent as above enables the formation of a zinc oxide thin film having a texture structure suitable for producing optical confinement effect.

As the electrically conductive substrate 203 is used the above-described substrate 101 with a metal layer 102 formed thereon. The counter electrode 204 of the apparatus is a buffed zinc plate and used as an anode. The zinc content in the zinc plate is preferably 90% or more and more preferably 99% or more.

The counter electrode 204 is controlled such that the current flow is approximately constant. The current value is preferably 0.1 mA/cm² to 100 mA/cm², more preferably 1 mA/cm² to 30 mA/cm² and optimally 3 mA/cm² to 15 mA/cm².

### (Semiconductor Layer)

As the material for semiconductor layers 105, 106 and 107 is used amorphous or microcrystalline Si, C or Ge or the alloy thereof. The layers also contain hydrogen and/or a halogen atom. The preferred content of such an atom is 0.1 to 40% by atom. The layers may also contain oxygen, nitrogen, etc. The concentration of these impurities is preferably 5 × 10¹⁹ cm⁻³ or less. To provide a p-type semiconductor, elements classified into the family of column III are added, whereas to provide an n-type semiconductor, elements classified into the family of column V are added.

In a stacked cell, it is preferable that the i-type semiconductor layer of the pin junction has a wider band gap near the light entering side and a narrower band gap far away from the light entering side. It is also preferable that in the inside of the i layer, the band gap has the minimum on the p-type layer side relative to the middle of the layer thickness.

For the doped layer on the light entering side is suitably used a less light-absorbing crystalline semiconductor or semiconductor having a wide band gap.

To form semiconductor layers, microwave (MW) plasma CVD or high frequency (RF, VHF) CVD is suitably used.

By one technique for the semiconductor deposition, for example, "an i-type layer with graded SiGe compositions is formed, where the Ge content is from 20 to 70% by atom" (refer to Japanese Patent Application Laid-Open No. H4-119843) can be used.

### (Transparent Electrode)

The transparent electrode 108 can also function as an anti-reflection coating, if the film thickness is properly established. The transparent electrode 108 is formed of a material such as ITO, ZnO or In₂O₃ by evaporation, CVD, spray, spin-on or immersion. The compound forming the electrode may contain a substance that changes the electric conductivity.

### (Collector electrode)

The collector electrode 109 is provided to improve the current collecting efficiency. The processes for forming the electrode include; for example, a process in which metal of a current collecting pattern is formed by sputtering using a mask, a process in which current collecting paste or solder paste is printed, and a process in which a metal wire is bonded with a conductive paste

Protective layers are sometimes formed on both sides of a photovoltaic device depending on the situation. A reinforcement such as a steel plate may be used in combination with the collector electrode.

### (Continuous Film Forming Apparatus with Substrate in a Continuous Length)

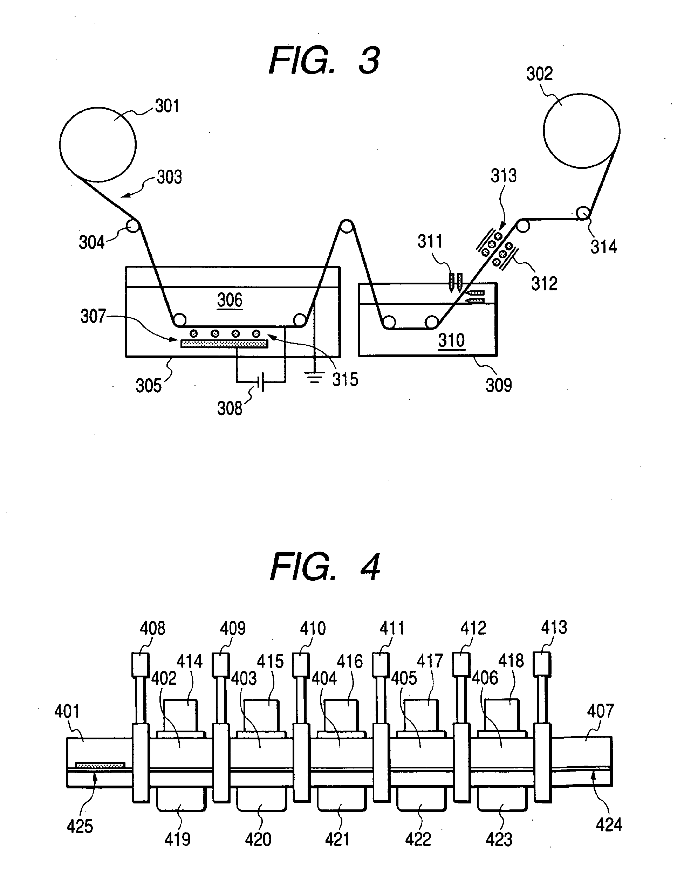

The process of depositing a zinc oxide thin film will be described using an apparatus shown in FIG. 3. In the same figure, reference numeral 301 denotes a delivery roller, numeral 302 a wind-up roller, numeral 303 a substrate in a continuous length, numeral 304 a conveying roller, numeral 305 a zinc oxide depositing tank, numeral 306 a zinc oxide depositing bath, numeral 307 a counter electrode, numeral 308 a DC power source, numeral 309 a cleaning tank, numeral 310 a pure water cleaning bath, numeral 311 a pure water shower, numeral 312 a drying chamber, numeral 313 an air hole, numeral 314 a meander correcting roller and numeral 315 an air ejecting opening.

The substrate in a continuous length 303 wound around the delivery roller 301 is conveyed via the path shown in FIG. 3 and wound into the wind-up roller 302 while its slight deviation is being corrected by the meander correcting roller 314.

The zinc oxide depositing bath 306 in the zinc oxide depositing tank 305 is the above-described aqueous solution for electrolytic deposition that contains nitric acid ion, zinc ion, and saccharose or dextrin.

The counter electrode 307 includes one or more square zinc plates of 99.99% purity. The DC power source 308 is controlled so that a voltage is applied across the substrate in a continuous length 303, as a cathode, and the counter electrode 307, as an anode, to keep current flow constant.

A uniform zinc oxide thin film in which anomalous growth is hardly detected can be formed efficiently by: keeping the temperature of the aqueous solution for electrolytic deposition at 50°C or more; and ejecting air through the air ejecting openings 315 provided on the sidewall of the zinc oxide depositing tank 305 with an air injection pump (not shown in the figure) at an ejecting rate of 1 to 100 cm³/h, preferably 5 to 50 cm³/h to stir the aqueous solution.

### (Plasma Treatment with Rare Gas or Nitrogen Gas and Semiconductor Deposition Apparatus)

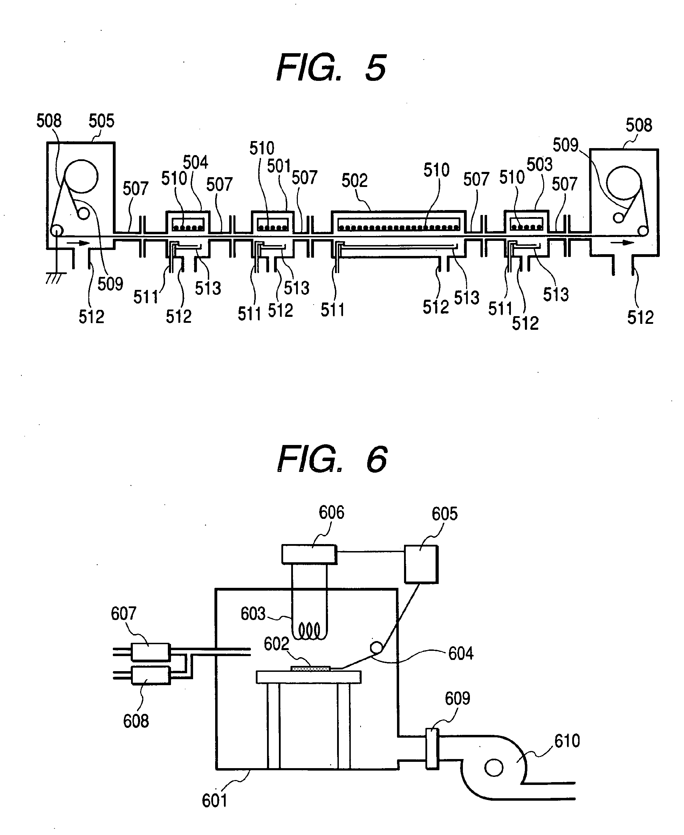

A photovoltaic device in accordance with this invention can be produced employing various types of production apparatuses and methods. When producing a single construction type of photovoltaic device shown in FIG. 1, for example, a production apparatus whose schematic view is shown in FIG. 5 can be used.

In FIG. 5, reference numerals 501, 502 and 503 denote deposition chambers for depositing n, i, p (or p, i, n)-type layer by high frequency plasma CVD, numeral 504 a plasma treatment chamber in which plasma treatment is carried out with a rare gas or nitrogen gas by high frequency plasma CVD, and numerals 505 and 506 a feeding chamber for feeding a conductive substrate strip and a wind-up chamber for winding up the same, respectively. The vacuum chambers of the respective deposition chambers are connected to each other via gas gates 507, which are narrow slits where a purge gas such as hydrogen gas is flowed to prevent the mixing of gases in the respective deposition chambers.

The substrate strip 508 is, for example, a conductive substrate strip of stainless steel sheet 0.13 mm thick and 36 cm wide. While the substrate strip is being wound off from the feeding chamber 505, continuously conveyed to pass through 4 deposition chambers 504, 501, 502 and 503 and wound up into the wind-up chamber 506, an adsorption preventive layer and a three-layered nip (or pin) structure silicon non-single crystal semiconductor film for a photovoltaic device are formed on the surface of the substrate strip.

Reference numeral 509 denotes a sheet strip of heat-resistant non-woven fabric, which is wound up into the wind-up chamber together with the substrate strip so as to prevent the surface of the substrate strip from being scratched.

Each of the deposition chambers 504, 501 502 and 503 is provided with a heater 510, a material gas introducing pipe 511 through which a material gas for depositing semiconductor is introduced into the deposition chamber from gas feeding means not shown in the figure, an exhaust pipe 512 for exhausting the chamber with exhaust means not shown in the figure to adjust pressure in the chamber to a specified value, and a discharge electrode 513 for inducing a glow discharge between a grounded substrate and itself by supplying high-frequency power from a high-frequency power source to the gas in the deposition chamber. And in the deposition chamber 504, plasma treatment with a rare gas or nitrogen gas is carried out and in the deposition chambers 501, 502 and 503, n, i, p (or p, i, n)-type silicon single crystal semiconductor layers are deposited by plasma CVD.

As described above, the plasma treatment with a rare gas or nitrogen gas is carried out by plasma CVD, just as is done the semiconductor deposition; therefore, the treatment chamber is easy to place in the front portion of the semiconductor deposition apparatus. As to the plasma treatment conditions, the treatment temperature is preferably the same as the temperature at which the doped layer adjacent to the zinc oxide layer is deposited and the treatment pressure is preferably 10 to 2,500 Pa. The making power is suitably in the range of 0.1 to 2.0 W, though it varies depending on the frequency of the high-frequency power source, the distance between the substrate and the cathode and the pressure in the chamber.

In the following, this invention will be described in detail in terms of suitable examples based on the accompanying drawings. However, it should be understood that these examples are not intended to limit the invention.

### (Example 1)

First, a zinc oxide film was formed using an electrolytic deposition apparatus shown in FIG. 2. As the substrate 203, as a cathode, was used a square stainless steel 430-2D plate with a side 50 mm long and thickness 0.15 mm which had on its surface a silver film 2,000 nm thick formed by applying 0.3 A constant current in an argon atmosphere at 0.399 Pa, 350°C with a sputtering apparatus (ULVAC SBH-2206DE). As the counter electrode 204, as an anode, was used a square zinc plate of 99.99% purity with a side 40 mm long and thickness 1.2 mm. The space between the counter electrode 204 and the substrate 203 was fixed to 50 mm.

As the aqueous solution 202 was used 0.15 mol/L zinc nitrate at 80°C with 12 g/L of saccharose having been added thereto, and the solution was stirred with the stirrer 214. Electrolytic deposition was carried out while carrying 3.0 mA/cm² of current between the counter electrode 204 as an anode and the substrate 203 as a cathode, which was grounded. The thickness of the zinc oxide film formed by the electrolytic deposition was 3.0 µm.

Then rare gas plasma treatment was performed using the apparatus shown in FIG. 4.

FIG. 4 is a schematic view showing one form of the suitable apparatus for forming semiconductor layers of a photovoltaic device of this invention. In the same figure, the deposition film forming apparatus consists mainly of: a load chamber 401, a rare gas plasma treatment chamber 402, a microcrystalline silicon i-type layer chamber 403, an amorphous silicon i-type layer RF chamber 404, an n-type layer RF chamber 405, a p-type layer RF chamber 406 and an unload chamber 407. The chambers are separated from each other with gate valves 408, 409, 410, 411, 412 and 413 such that the respective material gases should not be mixed together.

The rare gas plasma treatment chamber 402 consists of a heater 414 for heating the substrate and a plasma CVD chamber 419. The microcrystalline silicon i-type layer chamber 403 consists of a heater 415 for heating the substrate and a plasma CVD chamber 420. The RF chamber 404 includes an i-type layer depositing heater 416 and an i-type layer deposition chamber 421, the RF chamber 405 an n-type layer depositing heater 417 and an n-type layer deposition chamber 422, and the RF chamber 406 a p-type layer depositing heater 418 and a p-type layer deposition chamber 423.

The substrate is mounted on a substrate holder 425 and moved on a rail 424 with a roller driven from outside.

The substrate on which a zinc oxide film had been formed was introduced into the plasma treating chamber 402, and the treatment chamber was evacuated to a pressure of 100 Pa or less by an evacuation system not shown in the figure. After the evacuation, helium gas was introduced into the chamber while controlling its flow with a mass flow controller. Then the treatment chamber was evacuated to a pressure of 300 Pa while controlling the pressure in its inside. Plasma treatment was carried out for two minutes while supplying high-frequency power of 13.56 MHz and 1 W/cm² power density from a power source not shown in the figure via matching equipment to a discharge electrode provided in the deposition chamber 402. Then, the substrate was taken out from the plasma treatment chamber 402, and total reflectance and diffused reflectance, water content in the deposited film and electrical resistance were measured for the substrate.

The total reflectance and diffused reflectance were determined in the light wavelength region of 400 nm to 1,200 nm with a spectrometer (V-570, made by JASCO Corporation). The water content in the film was determined with a Karl Fischer moisture titrator (MKC-510, made by Kyoto Electronics manufacturing Co., Ltd.). And the electric resistance was determined in such a manner as to first form an upper electrode by evaporating metals of Cr and Au in this order onto the above zinc oxide film with a vacuum evaporation apparatus using a mask 0.25 cm² in size and measure the electric resistance between the stainless steel substrate and the upper electrode. Since the measurement system, including the measurement pointer, itself had a circuit resistance of about 0.1 Ωcm², the measurement of the electric resistance may have an error equivalent of such resistance.

### (Example 2)

A zinc oxide film was formed on a substrate in the same manner as in Example 1, and then the substrate 602 was introduced into a heat treatment chamber 601 shown in FIG. 6 and dehydrated for 10 minutes while increasing the temperature of the object to be treated (substrate) from room temperature up to 200°C in increments of 2.0°C/min and, after completing the temperature increase, controlling the same with a heater output system 606 so as to keep the object to be treated at 200°C. In FIG. 6, reference numeral 603 denotes a heater, numeral 604 a treatment chamber monitoring thermocouple, numeral 605 a heater output regulator, numeral 607 a nitrogen gas mass flow controller, numeral 608 an oxygen gas mass flow controller, numeral 609 a pressure regulating valve and numeral 610 an evacuating pump.

After completing the dehydration treatment, the heater output was turned off and the substrate was cooled to room temperature while keeping the oxygen-nitrogen flow rate ratio such that the partial pressure of oxygen is 2%. After cooled, the substrate with a zinc oxide film formed thereon was introduced into the plasma treatment chamber 402 shown in FIG. 4, and the treatment chamber was evacuated with a evacuating system not shown in the figure to a pressure of 100 Pa or less. After the evacuation, helium gas was introduced while controlling its flow with a mass flow controller. Then the treatment chamber was evacuated while controlling the pressure inside the chamber to be 300 Pa. Plasma treatment was carried out for two minutes while supplying high-frequency power of 13.56 MHz and 1 W/cm² power density from a power source not shown in the figure via matching equipment to a discharge electrode 419 provided in the deposition chamber 402. Then, the substrate was taken out from the plasma treatment chamber 402, and total reflectance and diffused reflectance, water content in the deposited film and electrical resistance were measured for the substrate in the same manner as in Example 1.

### (Comparative Example 1)

A silver film 2,000 nm thick was formed on the same substrate as used in Example 1 by applying 0.3 A constant current in an argon atmosphere at 0.399 Pa, 350°C with a sputtering apparatus (ULVAC SBH-2206DE). And 0.3 A constant current was applied to the zinc oxide target with the same sputtering apparatus, to deposit zinc oxide 3.0 µm. Then, the substrate was taken out, and total reflectance and diffused reflectance, water content in the deposited film and electrical resistance were measured for the substrate in the same manner as in Example 1.

### (Comparative Example 2)

The zinc oxide film was formed on a substrate in the same manner as in Example 1, but heat drying and rare gas plasma treatment were not performed. Then, total reflectance and diffused reflectance, water content in the deposited film and electrical resistance were measured for the substrate in the same manner as in Example 1.

### (Comparative Example 3)

The zinc oxide film was formed on a substrate in the same manner as in Example 1, and then the substrate 602 was introduced into a heat treatment chamber 601 shown in FIG. 6 and dehydrated for 10 minutes while increasing the temperature of the object to be treated (substrate) from room temperature up to 200°C in increments of 2.0°C/min and, after completing the temperature increase, controlling the same with a heater output system 606 so as to keep the object to be treated at 200°C.

After completing the treatment, the heater output was turned off and the substrate was cooled to room temperature while keeping the oxygen-nitrogen flow rate ratio such that the partial pressure of oxygen is 2%. After cooled, the substrate 602 was taken out from the heat treatment chamber 601, and total reflectance and diffused reflectance, water content in the deposited film and electrical resistance were measured for the substrate in the same manner as in Example 1.

Table 1 shows the measured results of Examples 1, 2 and Comparative Examples 1, 2 and 3.

**(Table 1)**

| | Zinc Oxide Depositing Process | Drying Process | | Reflectance | | Water Content (mol/ cm²) | Electric Resistance (Ω/cm2) |
|---|---|---|---|---|---|---|---|
| | | Heating | Rare Gas Plasma | Total Reflection | Diffused Reflection | | |
| Comparative Example 1 | Sputtering | - | - | 90 | 86 | 0.8×10⁻³ | 0.2-0.3 |
| Comparative Example 2 | Electrolytic Deposition | - | - | 93 | 90 | 8.0×10⁻³ | 9.0-10.0 |
| Comparative Example 3 | | O | - | 92 | 89 | 1.9×10⁻³ | 0.3-0.4 |
| Example 1 | | - | O | 92 | 89 | 1.9×10⁻³ | 0.3-0.5 |
| Example 2 | | O | O | 92 | 89 | 1.1×10⁻³ | 0.2-0.3 |

As is apparent from the results shown in Table 1, for the zinc oxide film formed by electrolytic deposition and in the as-formed state (Comparative Example 2), its total reflectance and diffused reflectance were high compared with the zinc oxide film formed by sputtering, and the water content in the film was about 10 times as much as that of the zinc oxide film formed by sputtering and the electric resistance was high. Thus, even if a photovoltaic device is formed on such a zinc oxide film, the device cannot be expected to have desired characteristics.

For the zinc oxide films of Comparative Example 3, Example 1 and Example 2, their total reflectance and diffused reflectance were good, even after drying, compared with the zinc oxide film formed by sputtering. Their water content was a little larger than that of the zinc oxide film formed by sputtering, but the electric resistance obtained was almost the same as that of the zinc oxide film formed by sputtering.

Then semiconductor layers were formed on each of the substrates obtained in Comparative Example 1, Comparative Example 3, Example 1 and Example 2 under the deposition conditions given for each layer as shown in table 2 with an apparatus shown in FIG. 4.

**(Table 2)**

| | | Deposition Gas (cm³/min (normal)) | | | | Power Density (W/cm²) | | Pressure (Pa) | substrate Temperature (°C) | Film Thickness (nm) |
|---|---|---|---|---|---|---|---|---|---|---|
| | | SiH4 | H₂ | PH₃ (2% H dilution) | BF₃ (2% H dilution) | RF | VHF | | | |
| First Photovoltaic Device | N2 | 1 | 50 | 0.5 | | 0.04 | | 180 | 225 | 20 |
| | I2 | 25 | 800 | | | | 0.2 | 40 | 250 | 1,800 |
| | P2 | 0.025 | 35 | | 1 | 1.2 | | 270 | 165 | 5 |
| Second Photovoltaic Device | N1 | 1 | 50 | 0.5 | | 0.04 | | 180 | 225 | 20 |
| | I1 | 2 | 50 | | | 0.05 | | 150 | 210 | 400 |
| | P1 | 0.025 | 35 | | 1 | 1.2 | | 270 | 165 | 5 |

First, each substrate was set in the substrate holder 425 and set on the rail 424 of the load chamber 401. Then the load chamber 401 was evacuated to a vacuum degree of several hundreds Pa or less.

Then, the gate valves 408, 409, 410 and 411 were opened and the substrate holder 425 was moved to the n-type layer deposition chamber 422 of the chamber 405. An n-type layer was deposited to a predetermined thickness with a predetermined material gas while keeping the gate valves 408, 409, 410, 411, 412 and 413 closed. After fully evacuating the chamber 405, the substrate holder 425 was moved to the deposition chamber 403 while keeping the gate valves 410 and 411 opened, and then the gate valves were closed. The substrate was heated with the heater 415 to a predetermined substrate temperature, and a microcrystalline silicon i-type layer was deposited on the substrate to a predetermined thickness by introducing a required amount of predetermined material gas into the chamber 403, evacuating the chamber 403 to a predetermined vacuum degree, introducing a predetermined microwave energy or VHF energy into the deposition chamber 420 to induce plasma.

Then, the chamber 403 was fully evacuated, the substrate holder 425 was moved from the chamber 403 to the p-type layer deposition chamber 423 of the chamber 406 while keeping the gate valves 410, 411, 412 open, and the substrate was heated with the heater 418 to a desired substrate temperature. A p-type layer was deposited to a desired thickness by supplying predetermined flow rate of material gas for p-type layer deposition and introducing RF energy into the deposition chamber 423 while keeping the chamber at a predetermined vacuum degree.

Subsequently, on the substrate on which a first photovoltaic device had been formed in the manner as described above, a pin-type amorphous Si:H photovoltaic device was formed as a second photovoltaic device in such a manner as described below.

An n-type layer was deposited under predetermined conditions in the same manner as described above. After fully evacuating the chamber 405, the substrate holder 425 was moved to the deposition chamber 404 while keeping the gate valve 411 opened, and then the gate valve was closed. The substrate was heated with the heater 416 to a predetermined substrate temperature, and an amorphous Si:H i-type layer was deposited on the substrate to a predetermined thickness in accordance with Table 2, while adjusting the deposition time, by introducing a required amount of predetermined material gas into the chamber 404, evacuating the chamber 404 to a predetermined vacuum degree, introducing a predetermined microwave energy into the deposition chamber 421 to induce plasma. Then, the chamber 404 was fully evacuated, and the substrate holder 425 was moved from the chamber 421 to the chamber 423 while keeping the gate valves 411, 412 open. And a p-type layer was deposited to a predetermined thickness under predetermined conditions in the same manner as above.

Then, the deposition chamber 423 was evacuated in the same manner as above, the gate valve 413 was opened, and the substrate holder 425 in which the substrate with semiconductor layers deposited thereon had been set was moved to the unload chamber 407. The substrate holder 425 was taken out from the unload chamber 407 in the same manner as above.

Then the substrate was mounted on the surface of the anode of a DC magnetron sputtering apparatus, the surrounding of the sample was shielded with a stainless steel mask, and on the region of the center portion 40 mm × 40 mm, tin indium oxide was deposited as a transparent electrode by sputtering using a target made up of 10% by weight of tin oxide and 90% by weight of indium oxide.

The deposition was performed so as to provide a film of 70 nm in about 100 seconds under the following conditions: substrate temperature 170°C; flow rates of argon, as an inert gas, 50 cm³/min (normal) and oxygen gas 0.5 cm³/min (normal); pressure in the deposition chamber 300 mPa; and making power per target unit area 0.2 W/cm². The film was allowed to have a predetermined thickness by calibrating in advance the relation between the deposition time and the film thickness under the same conditions.

The current-voltage characteristics of the resultant samples were measured, while irradiating the samples with light at a spectrum of AM 1.5 and an intensity of 100 mW/cm², with YSS-150 made by Yamashita Denso Corporation. The short-circuit current density (Jsc (mA/cm²)), open circuit voltage (Voc (V)), fill factor (FF) and photoelectric conversion efficiency (η (%)) were obtained for each sample from the measured current-voltage characteristics. The characteristic values were expressed in terms of the ratio of the values of each sample to those of the sample of comparative Example 1, which was formed by sputtering, and are summarized in Table 3.

**(Table 3)**

| | Jsc | FF | Voc | Eff. |
|---|---|---|---|---|
| Comparative Example 3/ Comparative Example 1 | 0.988 | 0.972 | 0.995 | 0.956 |
| Example 1/ Comparative Example 1 | 1.057 | 0.997 | 0.999 | 1.053 |
| Example 2/ Comparative Example 1 | 1.060 | 0.998 | 1.000 | 1.058 |

As is apparent from the results shown in Table 3, in the sample of Comparative Example 3, the total reflection and diffused reflection were both good compared with those of the sample of Comparative Example 1, but Jsc and FF were inferior to those of the sample of Comparative Example 1. The visual observation of the surface of the photovoltaic device confirmed a little peeling of the semiconductor layers.

In the samples of Examples 1 and 2, the results were good compared with those of the sample of Comparative Example 1. And no peeling was observed visually.

Reliability test was also conducted as follows. Each sample was introduced into a high-temperature and high-humidity tank and kept at a temperature of +85°C and a relative humidity of 85%. While testing, backward bias voltage -0.85 V was continued to apply to each sample for 20 hours. Then the sample was taken out from the tank and fully air dried and cooled, and the voltage-current characteristics were measured. The characteristics were expressed in terms of the relative values to the initial values and are shown in Table 4.

**(Table 4)**

| | Jsc | FF | Voc | Eff. | Rsh |
|---|---|---|---|---|---|
| Comparative Example 3 | 0.851 | 0.996 | 0.945 | 0.801 | 0.664 |
| Example 1 | 1.000 | 0.996 | 1.003 | 0.999 | 0.998 |
| Example 2 | 0.999 | 0.997 | 1.003 | 0.999 | 0.999 |

In the samples of Examples 1 and 2, the deterioration in shunt resistance was hardly observed in the reliability test. However, in the sample of Comparative Example 3, substantial deterioration in both shunt resistance and photoelectric conversion efficiency, which might be caused by the peeling of the semiconductor layers, was observed.

Then, using the apparatus shown in FIG. 4, first and second photovoltaic devices were formed on the substrates obtained in Comparative Examples 1 and 3 and Examples 1 and 2 under the given deposition conditions shown in Table 5 in the same manner as above, except that an adsorption preventive layer was formed in the n-type layer deposition chamber 422 of the chamber 405.

**(Table 5)**

| | | Deposition Gas (cm³/min(normal)) | | | | Power Density (W/cm²) | | Pressure (Pa) | Substrate Temperature (°C) | Film Thickness (nm) |
|---|---|---|---|---|---|---|---|---|---|---|
| | | SiH4 | H₂ | PH₃ (2% H dilution) | BF₃ (2% H dilution) | RF | VHF | | | |
| Adsorption Preventive Layer | N3 | 1 | 150 | 0.05 | | 0.06 | | 180 | 225 | 10 |
| First Photovoltaic Device | N2 | 1 | 50 | 0.5 | | 0.04 | | 180 | 225 | 20 |
| | I2 | 25 | 800 | | | | 0.2 | 40 | 250 | 1,800 |
| | P2 | 0.025 | 35 | | 1 | 1.2 | | 270 | 165 | 5 |
| Second Photovoltaic Device | N1 | 1 | 50 | 0.5 | | 0.04 | | 180 | 225 | 20 |
| | I1 | 2 | 50 | | | 0.05 | | 150 | 210 | 400 |
| | P1 | 0.025 | 35 | | 1 | 1.2 | | 270 | 165 | 5 |

The current-voltage characteristics of the resultant samples were measured, while irradiating the samples with light at a spectrum of AM 1.5 and an intensity of 100 mW/cm², with YSS-150 made by Yamashita Denso Corporation. The short-circuit current density (Jsc (mA/cm²)), open circuit voltage (Voc (V)), fill factor (FF) and photoelectric conversion efficiency (η (%)) were obtained for each sample from the measured current-voltage characteristics. The characteristic values were expressed in terms of the ratio of the values of each sample having an adsorption preventive film to those of the sample having no adsorption preventive film and are summarized in Table 6. As is apparent from the results shown in Table 6, in the samples of Examples 1 and 2, which were given rare gas plasma treatment, Eff was improved due to the improvement in Jsc. And no peeling was observed visually.

**( Table 6)**

| Adsorption Preventive Layer Presence/ Absence | Jsc | FF | Voc | Eff. |
|---|---|---|---|---|
| Example 1 | 1.050 | 0.998 | 0.997 | 1.045 |
| Example 2 | 1.055 | 0.999 | 0.999 | 1.053 |
| Comparative Example 1 | 1.003 | 0.999 | 1.000 | 1.002 |
| Comparative Example 2 | 1.001 | 0.999 | 1.000 | 1.000 |
| Comparative Example 3 | 1.010 | 0.998 | 1.000 | 1.008 |

Reliability test was also conducted as follows. Each sample was introduced into a high-temperature and high-humidity tank and kept at a temperature of +85°C and a relative humidity of 85%. While testing, backward bias voltage -0.85 V was continued to apply to each sample for 20 hours. Then the sample was taken out from the tank and fully air dried and cooled, and the voltage-current characteristics were measured. The characteristics were expressed in terms of the relative values to the initial values and are shown in Table 7.

In the samples of Examples 1 and 2, the deterioration in shunt resistance was hardly observed in the reliability test. However, in the sample of Comparative Example 3, substantial deterioration in both shunt resistance and photoelectric conversion efficiency, which might be caused by the peeling of the semiconductor layers, was observed.

**(Table 7)**

| | Jsc | FF | Voc | Eff. | Rsh |
|---|---|---|---|---|---|
| Comparative Example 3 | 0.853 | 0.996 | 0.945 | 1.000 | 0.665 |
| Example 1 | 1.000 | 0.996 | 1.002 | 0.998 | 0.998 |
| Example 2 | 0.999 | 0.998 | 1.002 | 0.999 | 0.999 |

The results so far show that a photovoltaic device produced using a substrate whose zinc oxide layer is formed by electrolytic deposition and subjected to rare gas plasma treatment is high in photoelectric conversion efficiency, excellent in adhesion among the semiconductor layers and high in reliability. Further, a photovoltaic device produced using a substrate on which an adsorption preventive layer is formed after the plasma treatment has further improved photoelectric conversion efficiency and is higher in reliability.

### (Example 3)

In this example, plasma treatment with a rare gas was given to a substrate on which a zinc oxide film had been formed by electrolytic deposition and then photovoltaic devices having a nip structure were continuously produced using a production apparatus shown in FIG. 5. The production conditions are shown in FIG. 8.

**(Table 8)**

| | Deposition Chamber | | | |
|---|---|---|---|---|
| | 504 | 501 | 502 | 503 |
| | Rare Gas Plasma-Treatment | n-Type Amorphous Silicon | i-Type Microcrystalline Silicon | p-Type Microcrystalline Silicon |
| Discharge Frequency (MHz) | 13.56 | 13.56 | 60 | 13.56 |
| Thickness of Semi-conductor | - | 20 | 1,500 | 10 |
| Gas (sccm) | | | | |
| SiH₄ | - | 10 | 150 | 20 |
| H₂ | - | 1,000 | 4,000 | 5,000 |
| SiF₄ | - | - | 400 | - |
| PH₃ | - | 0.5 | - | - |
| BF₃ | - | - | - | 5 |
| He | 1,000 | - | - | - |
| Substrate Temperature (°C) | 250 | 250 | 250 | 200 |
| Discharge Power (W) | 150 | 100 | 3,000 | 2,500 |
| Deposition Pressure (Pa) | 550 | | | |
| Conveying Speed (cm/min) | 100 | | | |

In the following the process of photovoltaic device production will be described in a step by step manner.
(1) A ZnO layer was formed, using an apparatus shown in FIG. 3, on a sheet stainless steel strip (36 cm wide × 50 m long × 0.15 mm thick) made up of SUS430-2D, on which an Ag layer as a lower electrode was formed in advance by a roll-to-roll sputtering apparatus not shown in the figure, under the conditions that allowed the texture degree of the layer to be increased.
(2) The sheet stainless steel strip (36 cm wide × 50 m long × 0.15 mm thick) 508 with a ZnO layer formed on its surface was wound around a bobbin and set together with the bobbin in the feeding chamber 505 of an apparatus shown in FIG. 5, and then it was passed through the deposition chambers 501 to 504 via each gas gate 507, laid across the deposition chambers and the wind-up chamber 506, and tensioned to a degree that it did not slack. In the wind-up chamber 506, a bobbin around which a fully dried aramid protective film (36 cm wide × 60 m long × 0.05 mm thick) 509 had been wound was set such that the protective film was wound into the wind-up chamber 506 together with the substrate strip with semiconductor films formed thereon.
(3) After setting the substrate strip, each of the chambers 501 to 506 was evacuated with a pump, which was a combination of a rotary pump and a mechanical booster pump, not shown in the figure, and He gas was introduced into each chamber while continuing the evacuation and the inside of each chamber was heated to about 300°C and baked in a He atmosphere at about 200 Pa.
(4) After the heat baking, each of the chambers 501 to 506 was evacuated again, and 1,000 sccm of H₂, as a gas for preventing the mixing of the deposition gases in the adjacent deposition chambers, was introduced into each gas gate 507 and a predetermined flow rate of material gas was introduced into each of the chambers 501 to 504 through each material gas introducing pipe 511, while continuing the evacuation. The internal pressure of the substrate feeding chamber 505 and the wind-up chamber 506 was set to 595 Pa and that of the deposition chambers 501, 502 and 504 was set to 600 Pa by regulating the opening of the throttle valve provided on each exhaust pipe 512.
(5) When the pressure of each chamber was stabilized, the wind-up bobbin of the wind-up chamber 506 for winding up the substrate was rotated so that the substrate strip 508 was continuously moved at a constant speed of 100 cm/min in the direction away from the deposition chamber 504 toward the deposition chamber 503. Further the temperature of the substrate was controlled with the heater 510 connected to a temperature controller, not shown in the figure, provided in each of the deposition chambers 501 to 504 such that the moving substrate strip had a predetermined temperature in the deposition space of each deposition chamber.
(6) When the temperature of the substrate strip was stabilized, high-frequency power of 13.56 MHz was applied to the discharge electrodes 513 provided in the deposition chambers 501, 503 and 504 and that of 60 MHz to the discharge electrode 513 provided in the deposition chamber 502 from a power source, not shown in the figure, via matching equipment. The application of discharge power allowed the material gas in each of the deposition chambers 501 to 504 to be brought to the plasma state, whereby semiconductor layers were formed on the surface of the continuously moving substrate strip in each deposition chamber. Thus, rare gas plasma treatment was continuously given the surface of the substrate strip and semiconductor film having a nip structure was formed on the same.
(7) After completing the rare gas plasma treatment and the semiconductor film formation, the operations such as the application of discharge power, the introduction of material gases and the heating of the substrate strip and the deposition chambers were all stopped, the deposition chambers were purged, the substrate strip and the inside of the apparatus was fully cooled, and the apparatus was opened to take out the substrate strip from the wind-up chamber 506.
(8) The substrate strip having been taken out from the apparatus was continuously processed with a continuous processing apparatus so that an ITO (In₂O₃ + SnO₂) thin film 70 nm thick was formed as a transparent electrode on the entire surface of the formed semiconductor layers and Ag electrodes in a fine linear form were formed as collector electrodes at specific intervals, thereby photovoltaic devices 30 cm × 30 cm were produced. A schematic view of the layer construction of the produced photovoltaic devices is shown in FIG. 1.

### (Example 4)

This example is different from Example 3 in that rare gas plasma treatment was not performed. Specifically, in this example, semiconductor layers were formed in the same manner as in Example 3, except that the substrate 501 was passed through the rare gas plasma treatment chamber 504 of the production apparatus shown in FIG. 5 where He gas was introduced through the material gas introducing pipe 511 and high-frequency power was not supplied to the discharge electrode 513. Excepting the above point, photovoltaic devices 30 cm × 30 cm with an n-i-p configuration were produced in the same manner as in Example 3.

The characteristic values were expressed in terms of the ratio of the values of the sample of Comparative Example 4 to those of the sample of Example 3 (Comparative Example 4/Example 3) and are summarized in Table 9.

**(Table 9)**

| | Jsc | FF | Voc | Eff. |
|---|---|---|---|---|
| Comparative Example 4 /Example 3 | 0.998 | 0.922 | 1.000 | 0.920 |

Reliability test was also conducted as follows. Each sample was introduced into a high-temperature and high-humidity tank and kept at a temperature of +85°C and a relative humidity of 85%. While testing, backward bias voltage -0.85 V was continued to apply to each sample for 20 hours. Then the sample was taken out from the tank and fully air dried and cooled, and the voltage-current characteristics were measured. The characteristics were expressed in terms of the relative values to the initial values and are shown in Table 10.

**(Table 10)**

| | Jsc | FF | Vbc | Eff. |
|---|---|---|---|---|
| Example 3 | 1.001 | 0.996 | 1.003 | 1.000 |
| Comparative Example 4 | 0.965 | 0.980 | 1.002 | 0.947 |

In the sample of comparative example 4, its FF (fill factor) substantially deteriorated, compared with the sample of Example 1, due to insufficient removal of water in the zinc oxide film. In the reliability test, in the sample of Comparative Example 4, deterioration in photoelectric conversion efficiency was observed due to the substantial deterioration in Jsc. And a large number of peeling portions were observed visually, which may be the cause of the deterioration in Jsc.

The results show that a photovoltaic device produced on a substrate whose zinc oxide layer is formed by electrolytic deposition and subjected to rare gas plasma treatment is good in initial photoelectric conversion efficiency and high in reliability.

There is disclosed a method of producing a photovoltaic device, characterized in that it includes steps of: a step of forming a zinc oxide layer on a substrate at least by electrolytic deposition; subjecting the zinc oxide layer to any one treatment selected from the group consisting of plasma treatment with a rare gas or nitrogen gas, ion irradiation, light irradiation and electromagnetic irradiation; and forming on the zinc oxide layer a semiconductor layer that are made up of a non-single crystal silicon material containing hydrogen and have at least one p-i-n junction.

## Claims

1. A method of producing a photovoltaic device, comprising steps of:
forming a zinc oxide layer on a substrate at least by electrolytic deposition;
subjecting the zinc oxide layer to any one treatment selected from the group consisting of plasma treatment with a rare gas or nitrogen gas, ion irradiation, light irradiation and electromagnetic irradiation; and
forming on the zinc oxide layer a semiconductor layer comprising a non-single crystal silicon material containing hydrogen and having at lease one p-i-n junction.

2. The method of producing a photovoltaic device according to claim 1, wherein the treatment is a rare gas plasma treatment using at least one rare gas selected from the group consisting of He, Ne, Ar, Kr and Xe.

3. The method of producing a photovoltaic device according to claim 1, wherein before forming the zinc oxide layer, another zinc oxide layer is formed on the substrate by sputtering and used as an underlying layer.

4. The method of producing a photovoltaic device according to claim 1, wherein the average thickness of the zinc oxide layer is from 10 nm to 5 µm inclusive.

5. The method of producing a photovoltaic device according to claim 1, wherein the zinc oxide layer transmits 50% or more of light with a wavelength of 800 nm.

6. The method of producing a photovoltaic device according to claim 1, wherein the zinc oxide layer has a resistivity lower than that of a p- or n-type semiconductor layer provided adjacent to the zinc oxide layer.

7. The method of producing a photovoltaic device according to claim 1, wherein an adsorption preventive layer is provided between the zinc oxide layer and a p- or n-type semiconductor layer provided adjacent to the zinc oxide layer.
